# EUROPEAN PATENT APPLICATION

(11) **EP 4 459 012 A1**
(43) Date of publication of application: **06.11.2024**
(21) Application number: 22915625.2
(22) Date of filing: 01.12.2022
(51) Int. Cl.: C25D 1/02, C25D 1/20, G01R 1/06, G01R 1/067

(54) **METHOD FOR PRODUCING ELECTROCAST TUBE**

(30) Priority: 27.12.2021 JP 2021212214
(71) Applicant: Nanshin Co., Ltd, Kamiina-gun Nagano 399-3702 (JP)
(72) Inventor: TANAKA Takaomi, Kamiina-gun, Nagano 399-3702 (JP)
(74) Representative: Liesegang, Eva
(86) International application number: PCT/JP2022/044420
(87) International publication number: WO 2023/127394

(57) **Abstract**

A method of manufacturing an electroformed pipe according to the present invention includes a core wire member preparation step (S 1), a conductive layer forming step (S3), a support layer forming step (S5), a support-layer-formed core wire member cutting step (S7), a crack forming step (S9), a gap forming step (S11), a fixing step (S13), a block cutting step (S15), a core wire member removing step(S17), and a resin removing step(S19).

According to the method of manufacturing an electroformed pipe of the present invention, it is possible to provide the manufacturing method that can overcome at least one of problems that is, a problem that a conductive layer 2 is liable to be easily peeled off from a core wire member 1, a problem that flaws are liable to easily occur on the conductive layer 2, or a problem that an electroformed pipe 4 is liable to be easily deformed.

## Description

### Technical Field

The present invention relates to a method of manufacturing an electroformed pipe.

### Background Art

Recently, in various fields, a demand for an elongated pipe having an extremely small outer diameter has been increased. As such a pipe, there has been known a metal-made pipe called a microtube, a micropipe or the like that is used in fields such as a pipe for a contact probe in the inspection of a semiconductor, a pipe for optical-communication-use connector, a pipe for optical-use metal ferule, a nozzle, or a pipe for a needle.

Among these pipes, for example, the pipe for a contact probe used in inspection of a semiconductor is used in a probe device for inspection of a semiconductor that inspects whether or not a semiconductor integrated circuit (LSI) is manufactured as designed. Such a device includes a large number of contact probes where a spring is disposed in a pipe and a pin is disposed in the pipe in an advanceable and retractable manner. The contact probe is used for inspecting a semiconductor by bringing an electrode of a semiconductor into contact with a pin.

Accordingly, an elongated pipe having an extremely small outer diameter is demanded, and such a pipe is requested to satisfy qualities such as favorable electric conductivity in a hollow pipe and no distortion in a hollow cross section.

However, along with a demand for higher integration and further miniaturization of a semiconductor in recent years, it has become increasingly difficult to manufacture high-quality tubes.

Japanese patent No. number 3889689 (Patent Literature 1) discloses a method for manufacturing an electroformed pipe that is provided for satisfying such a demand of high quality. In such a method, a fine wire member (core wire member) made of stainless steel and having an outer peripheral surface on which a conductive layer made of metal that is a material different from an electrodeposited material or a surrounding material is formed is provided. The electroformed material or the surrounding material (a support layer) is formed around the fine wire member by electroforming, and an electroformed pipe is manufactured by removing the fine wire member (core wire member) while leaving the conductive layer on an inner surface of the electroformed material or the surrounding material (the support layer). That is, the fine wire member (the core wire member) having the periphery on which the electroformed material or the surrounding material (the support layer) is formed by electroforming is gripped from above, and pulled from one side or both sides so as to be deformed to decrease a cross-sectional area of the fine wire member so that a gap is formed between the deformed fine wire member (the core wire member) and the conductive layer, and the deformed fine wire member (core wire member) is removed by pulling.

### [Prior Literature Art]

### [Patent Literature]

[Patent Literature 1] Japanese patent No.3889689

### [Summary of Invention]

### [Problem to be solved]

The above method seems to be a good method. However, a gripping portion of the fine wire member (the core wire member) to be gripped, for decreasing a cross-sectional area of the fine wire member (core wire member), is liable to be largely deformed from an inner diameter of the support layer, formed of the electroformed material or the surrounding material, due to a gripping force. On the other hand, when such a portion is cut by scissors, a nipper or the like from above the support layer, burrs or the like are liable to be formed at a cut portion of the fine wire member (the core wire member). Accordingly, when the fine wire member (core wire member) is removed by pulling, serious problems in terms of quality are liable to be caused. That is, the easy peeling off of the conductive layer from the fine wire member (the core wire member), the easy generation of flaws on the conductive layer and the easy deformation of the electroformed pipe are liable to be caused.

In view of above-mentioned circumstances, it is an object of the present invention to provide a method of manufacturing an electroformed pipe that can overcome at least one of these serious problems in terms of quality, that is, the easy peeling off of the conductive layer from the fine wire member (the core wire member), the easy generation of flaws on the conductive layer and the easy deformation of an electroformed pipe.

A method of manufacturing an electroformed pipe according to the present invention is a method of manufacturing an electroformed pipe by forming a support layer, formed with an electrodeposited material or surrounding material by electroforming, around a core wire member that has an outer peripheral surface on which a conductive layer is formed,
and the core wire member is removed while leaving the conductive layer on an inner surface of the support layer, wherein
the method of manufacturing an electroformed pipe comprising:
a core wire member preparation step of preparing the core wire member that is used in manufacturing the electroformed pipe;
a conductive layer forming step of forming a conductive layer by electroforming around the core wire member using electrolytic plating thus forming a conductive-layer-formed core wire member;
a support layer forming step of forming a support layer by electroforming around the conductive-layer-formed core wire member using electrolytic plating thus forming a support-layer-formed core wire member;
a support-layer-formed core wire member cutting step of cutting the support-layer-formed core wire member to a predetermined length;
a crack forming step of forming a crack in the support layer by swinging the cut support-layer-formed core wire member while gripping one end or both ends of the support-layer-formed core wire member in a long axis direction thus forming a crack-formed support-layer-formed core wire member;
a gap forming step of pulling the crack-formed support-layer-formed core wire member while gripping the crack-formed support-layer-formed core wire member thus deforming the crack-formed support-layer-formed core wire member such that a cross-sectional area of the core wire member beyond the crack is decreased whereby a gap is formed between the deformed core wire member and the conductive layer thus forming a gap-support-layer-formed core wire member;
a fixing step of arranging a plurality of the gap-support-layer-formed core wire members in parallel, on a cutting jig on which a wall or grooves are formed, along the wall or the grooves, and fixing the gap-support-layer-formed core wire members by a resin thus forming a core wire member fixing block;
a block cutting step of forming a post-cut core wire member fixing block by cutting the core wire member fixing block in a short axis direction of the core wire members thus forming the post-cut core wire member fixing block;
a core wire member removing step of removing a core wire members from the post-cut core wire member fixing block, in liquid or in air, by inclining the post-cut core wire member fixing block such that a long axis direction of the core wire members becomes a vertical direction or by cleaning thus forming the core wire member removed fixing block; and
a resin removing step of removing the resin from the core wire member removed fixing block thus forming an electroformed pipe while leaving the conductive layer on an inner surface of the support layer.

According to the method of manufacturing an electroformed pipe of the present invention, the support-layer-formed core wire member is formed into the crack-formed support-layer-formed core wire member where a crack is formed in the support layer in the crack forming step. The crack-formed support-layer-formed core wire member is formed into the gap support-layer-formed core wire member where a gap is formed between the core wire member and the conductive layer in the gap forming step. The core wire member fixing block where the plurality of gap support-layer-formed core wire members are arranged in parallel and are fixed by the resin is formed in the fixing step. The post-cut core wire member fixing block is formed by cutting the core wire member fixing block in the short axis direction of the core wire members in the block cutting step. The core wire member removed fixing block from which the core wire members are removed is formed by inclining or cleaning the post-cut core wire member fixing block in the core wire member removing step. The resin is removed from the core wire member removed fixing block in the resin removing step thus manufacturing the electroformed pipes where the conductive layer is left on the inner surface of the support layer. Therefore, deformed or burred core wire members are not pulled and removed from inside of the conductive layer, and it is possible to overcome at least one of serious problems relating to quality, that is, a problem that the conductive layer is liable to be easily peeled off from the fine wire member (the core wire member) at the time of removing the core wire member by pulling, a problem that flaws are liable to easily occur on the conductive layer, or a problem that the electroformed pipe is liable to be easily deformed.

### Brief Description of Figures

Fig. 1 is a figure for explaining the summary of a method of manufacturing an electroformed pipe according to an embodiment 1.
Fig. 2 is a figure for explaining an annealing step (a core wire member preparation step S1) in the method of manufacturing an electroformed pipe according to the embodiment 1.
Fig. 3 is a figure for explaining a layered structure such as a passivation film F, a conductive layer 2, a support layer 3 and the like, which are formed by the method of manufacturing an electroformed pipe according to the embodiment 1.
Fig. 4 is a figure for explaining a conductive layer forming step (S3) and a support layer forming step (S7) in the method of manufacturing an electroformed pipe according to the embodiment 1.
Fig. 5 is a figure for explaining an electrolytic plating treatment (the conductive layer forming step S3 and the support layer forming step S7) in the method of manufacturing an electroformed pipe according to the embodiment 1.
Fig. 6 is a figure for explaining a support-layer-formed core wire member 13 in the method of manufacturing an electroformed pipe according to the embodiment 1.
Fig. 7 is a figure for explaining a crack forming step (S9) in the method of manufacturing an electroformed pipe according to the embodiment 1.
Fig. 8 is a figure for explaining a gap forming step (S11) in the method of manufacturing an electroformed pipe according to the embodiment 1.
Fig. 9 is a figure for explaining a fixing step (S13) in the method of manufacturing an electroformed pipe according to the embodiment 1.
Fig. 10 is a figure for explaining a block cutting step (S15) in the method of manufacturing an electroformed pipe according to the embodiment 1.
Fig. 11 is a figure for explaining a core wire member removing step (S17) in the method of manufacturing an electroformed pipe according to the embodiment 1.
Fig. 12 is a figure for explaining a resin removing step (S19) in the method of manufacturing an electroformed pipe according to the embodiment 1.
Fig. 13 is a diagram for explaining a summary of the steps of the method of manufacturing an electroformed pipe according to the embodiment 1.
Fig. 14 is a diagram for explaining a summary of steps of methods of manufacturing an electroformed pipe according to embodiments 2 to 9.
Fig. 15 is a diagram for explaining a summary of steps of methods of manufacturing an electroformed pipe according to embodiments 10 and 11.

### [Description of embodiments]

Hereinafter, a method of manufacturing an electroformed pipe according to the present invention is explained while suitably referencing figures. The respective figures explained hereinafter are schematic figures expressing actual shapes, constitutions, methods and the like in a simplified manner. And each embodiment does not restrict the claimed invention. It is not always the case that all of the constitutional elements explained in the respective embodiments and all combinations of these constitutional elements are indispensable in the present invention. In the description made hereinafter, there may be a case where the same symbols are used over the embodiments and the repeated descriptions are omitted, with respect to the constitutional elements, the steps (treatments) and the like that are regarded substantially equal.

### [Embodiment 1]

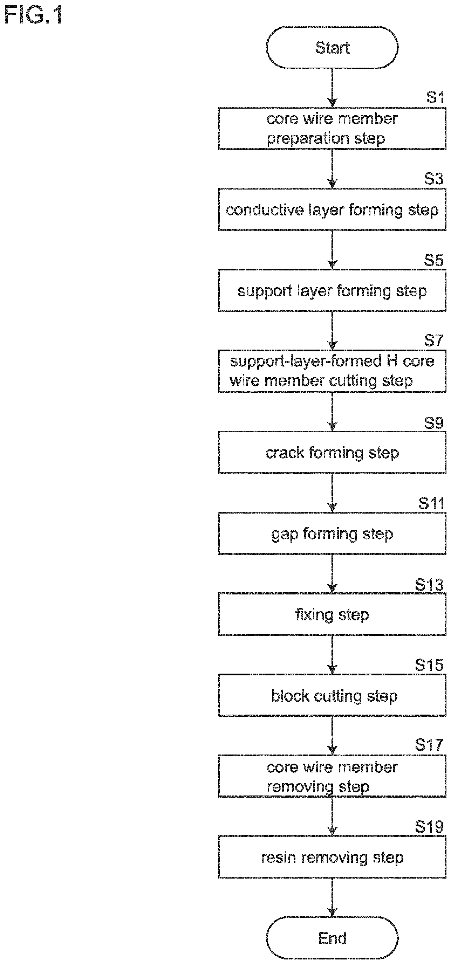

Fig. 1 to Fig. 13 are figures for explaining a method of manufacturing an electroformed pipe according to an embodiment 1. The method of manufacturing an electroformed pipe according to the embodiment 1 is explained with reference to these figures.

### [Summary of method of manufacturing an electroformed pipe]

Fig. 1 is a figure for explaining the summary of a method of manufacturing an electroformed pipe according to an embodiment 1. (In this specification, there may be a case where "step Sxx" is written as "Sxx"".

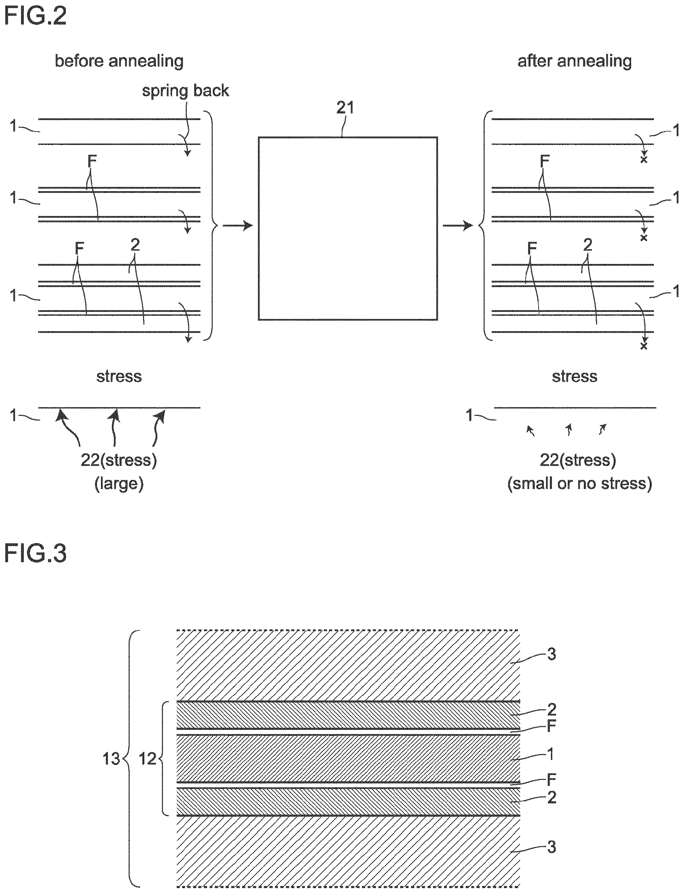

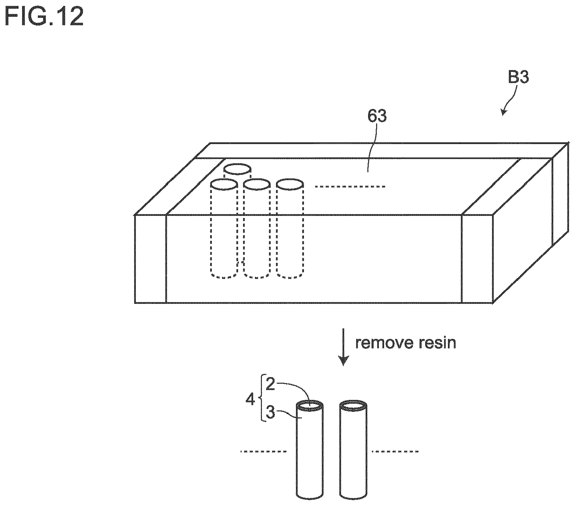

The method of manufacturing an electroformed pipe according to the embodiment 1 is a method of manufacturing an electroformed pipe 4 (see Fig. 12 described later), where a support layer 3 that is formed with an electrodeposited material or a surrounding material formed by electroforming is formed around a core wire member 1 having an outer peripheral surface on which a conductive layer 2 (see Fig. 3 described later) is formed, and the core wire member 1 is removed while leaving the conductive layer 2 on an inner surface of the support layer 3.

The manufacturing method includes: a core wire member preparation step (S1); a conductive layer forming step (S3); a support layer forming step (S5); a support-layer-formed core wire member cutting step (S7); a crack forming step (S9)); a gap forming step (S11); a fixing step (S13); a block cut step (S15); a core wire member removing step (S17); and a resin removing step (S19) (see Fig. 1).

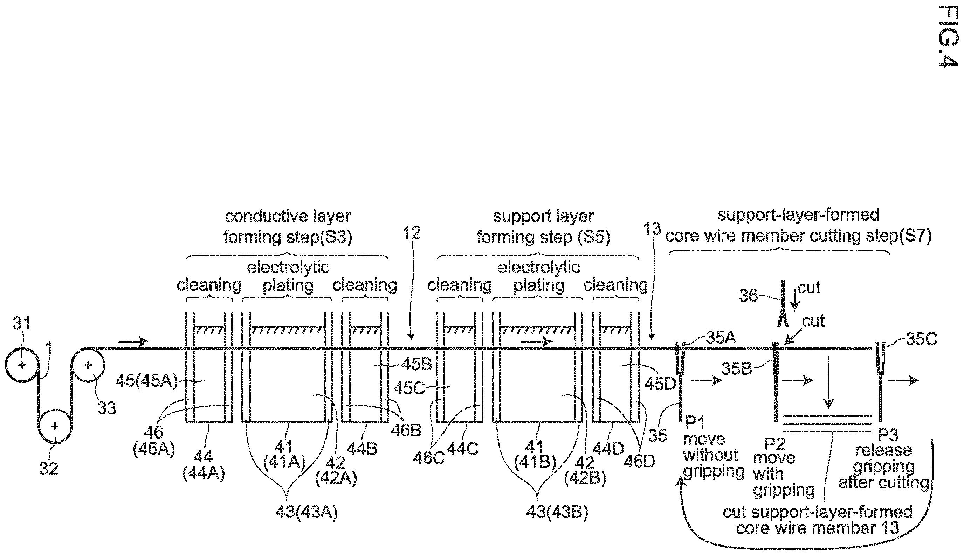

To simply explain the respective steps in S1 to S19, in the core wire member preparation step (S1), the core wire member 1 used for manufacturing the electroformed pipe 4 is prepared (described later using Fig. 3 and Fig. 4). In the conductive layer forming step (S3), the conductive layer 2 is formed around the core wire member 1 by electroforming using electrolyte plating thus forming a conductive-layer-formed core wire member 12 (described later using Fig. 4 to Fig. 6). In the support layer forming step (S5), the support layer 3 is formed around the conductive-layer-formed core wire member 12 thus forming the support-layer-formed core wire member 13 (described later using Fig. 4 to Fig. 6).

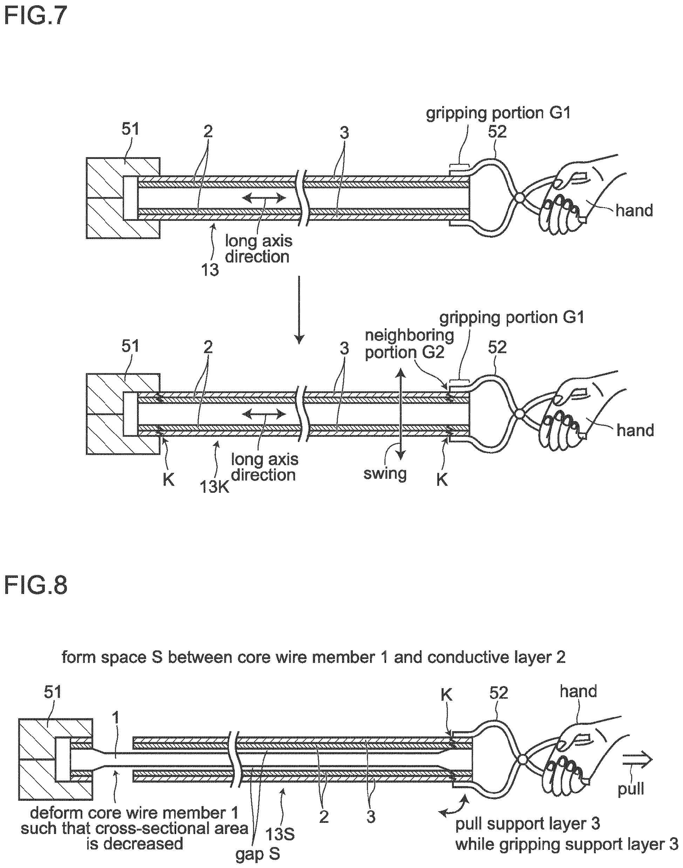

In the support-layer-formed core wire member cutting step (S7), the support-layer-formed core wire member 13 is cut to a predetermined length (described later using Fig. 4). In the crack forming step (S9), the cut support-layer-formed core wire member 13 obtained by cutting is swung, in a state where one end or both ends of the cut support-layer-formed core wire member 13 in the long axis direction are gripped, thus producing a crack-formed support-layer-formed core wire member 13K, in which crack K, is formed (described later using Fig. 7). In the gap forming step (S11), by pulling the crack-formed support-layer-formed core wire member 13K while gripping the crack-formed support-layer-formed core wire member 13K, a portion of the core wire member 1 beyond the crack K is deformed such that a cross-sectional area of the portion of the core wire member 1 is decreased whereby a gap S is formed between the deformed core wire member 1 and the conductive layer 2, thus a gap support-layer-formed core wire member 13S is formed (described later using Fig. 8).

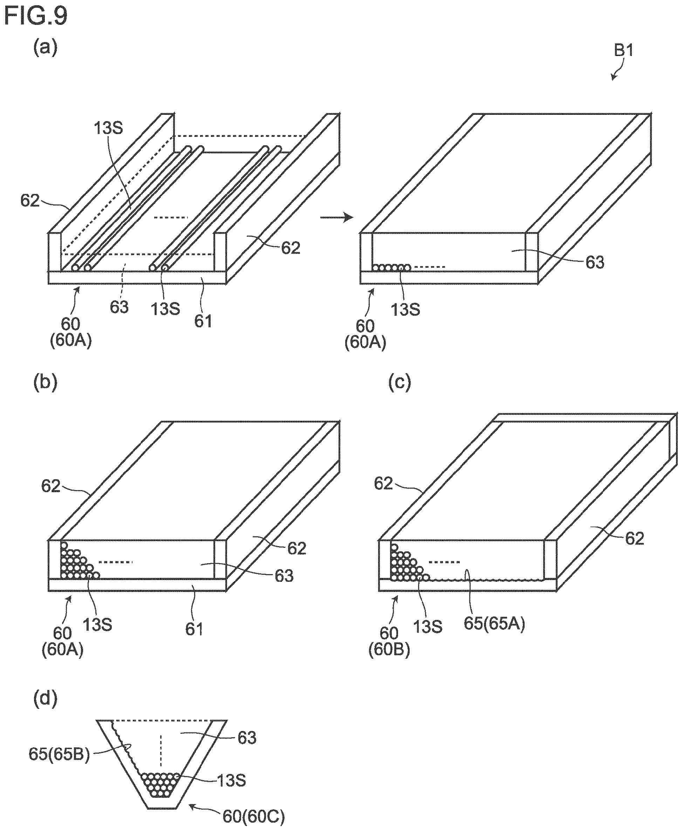

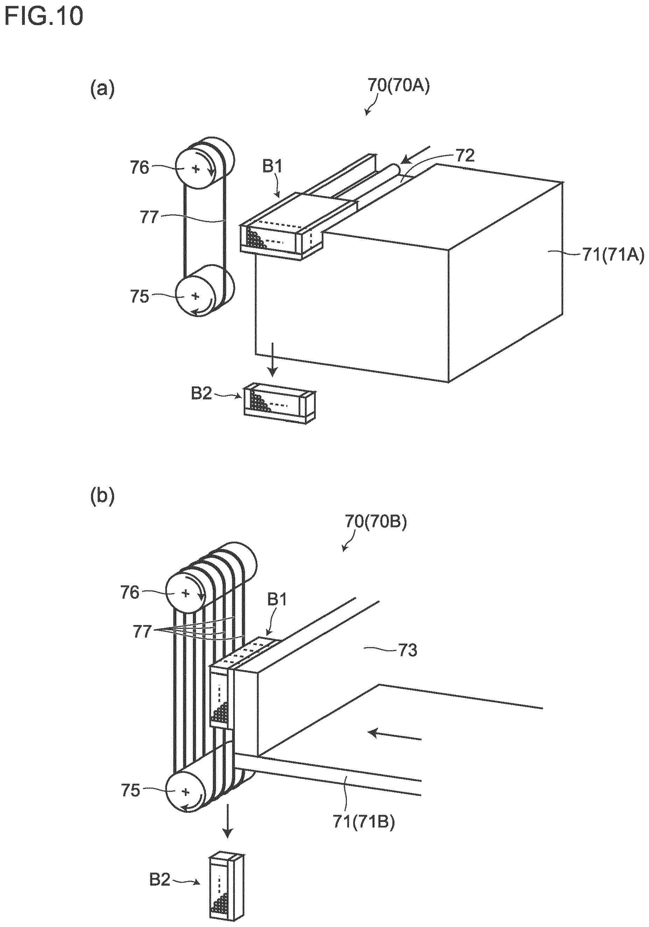

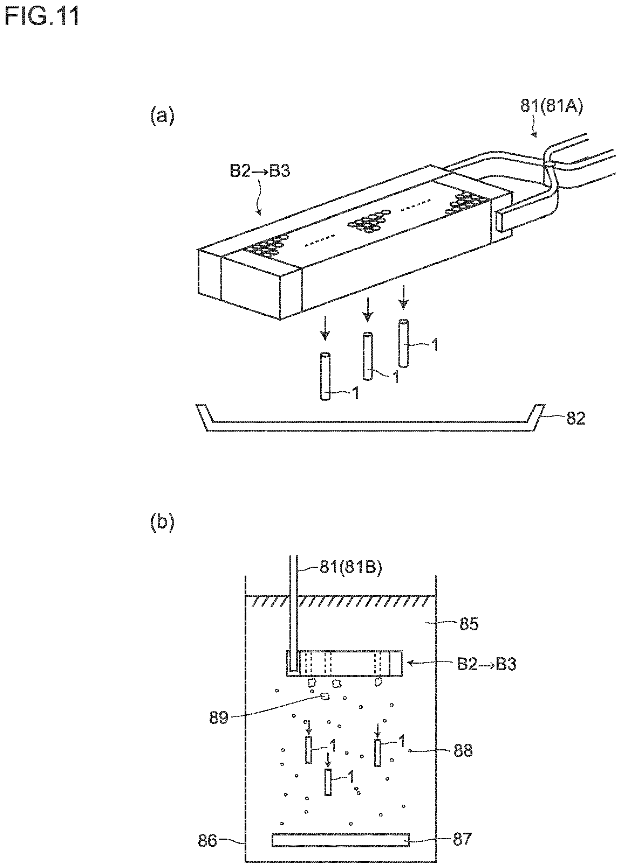

In the fixing step (S13), a plurality of gap support-layer-formed core wire members 13S are arranged in parallel on a cutting jig 60, on which walls 62 and grooves 65 are formed along the walls 62 and the grooves 65, and they are fixed by resin 63, thus forming a core wire member fixing block B1 (described later using Fig. 9). In the block cutting step (S15), the core wire member fixing block B1 is cut in a short axis direction of the core wire members 1, thus forming a post-cut core wire member fixing block B2 (described later using Fig. 10). In the core wire member removing step (S 17), the core wire members 1 are removed in liquid or in air, by inclining the post-cut core wire member fixing block B2 such that a long axis direction of the core wire members 1 becomes a vertical direction, or by cleaning the post-cut core wire member fixing block B2, thus forming a core wire member removed fixing block B3 (described later using Fig. 11). In the resin removing step (S19), the resin 63 is removed from the core wire member removed fixing block B3, thus forming electroformed pipes 4 while leaving the conductive layer 2 on an inner surface of the support layer 3 (described later using Fig. 12).

Even in a case where the core wire members 1, the support layer 3 and the like are deformed at the gripped portions of the crack-formed support-layer-formed core wire member 13K in the gap forming step (S11), the deformed portions are cut and removed in the block cutting step (S15). Alternatively, the deformed portions are cut and removed in the cutting step (the gap support-layer-formed core wire member cutting step described later), between the gap forming step (S11) and the block cutting step (S15) or the like. Accordingly, the post-cut core wire member fixing block B2 is a block that has the core wire members 1 and the support member 3 which are not deformed and the like by gripping. In the core wire member removing step (S17), the core members 1 are removed from such post-cut core wire member fixing block B2.

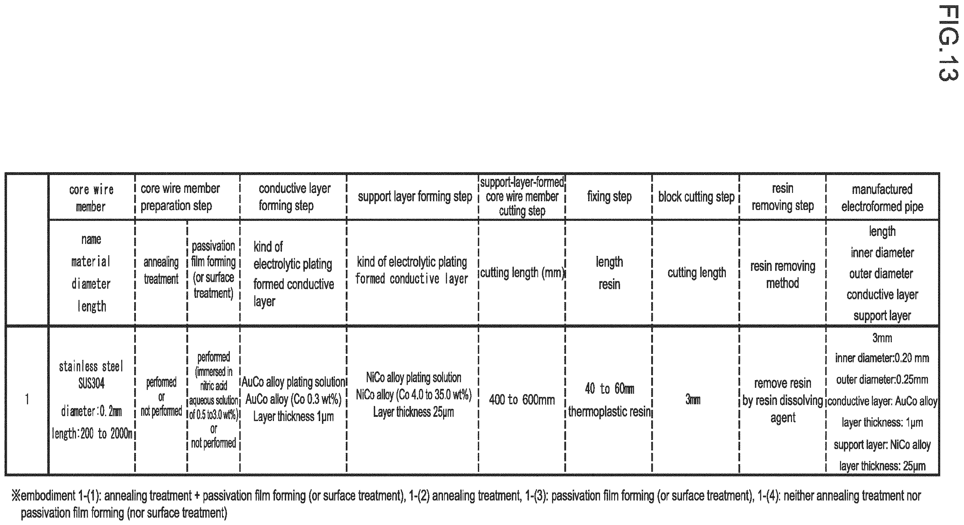

With respect to step outline of the method of manufacturing electroformed pipe according to the embodiment 1, materials, sizes and the like of the core wire member 1, the conductive layer 2, the support layer 3 and the like are collectively described in Fig. 13 (described later).

### [Core wire member preparation step (S1)]

### [Core wire member 1]

As a material of the core wire member 1, stainless steel that contains chromium in iron, more specifically, SUS304 that is (Cr-Ni-based) austenite stainless steel is used. The core wire member 1 is a wire member having a diameter of 0.2 mm (cross section being circular) and a wire length of 200 to 2000 m.

### [Annealing]

In the method of manufacturing an electroformed pipe according to the embodiment 1, in the core wire member preparation step (S1), the core wire member 1 may be subjected to annealing treatment, in a case where the core wire member 1 is a core wire member that is hardened by being subjected to wire pulling treatment by which a cross-sectional area of the core wire member 1 is decreased.

Fig. 2 is a figure for explaining an annealing step (a core wire member preparation step S1) in the method of manufacturing an electroformed pipe according to the embodiment 1. On a left side of Fig. 2, the core wire member 1 before annealing is shown. The core wire member 1 before annealing may be a core wire member having a passivation film F or a core wire member having the passivation film F and the conductive layer 2 (the passivation film F being described later). A material of this core wire member 1 is stainless steel SUS304.

The core wire member 1 before annealing is subjected to wire pulling treatment (processing) where a stainless wire having a large diameter is made to pass through a slightly narrow hole (dies) so that the stainless steel wire is gradually narrowed. The core wire member 1 is hardened by the wire pulling treatment (processing), so that the core wire member 1 has a large stress 22 therein (see a left lower side in Fig. 2).

Such a core wire member 1 is charged into a heat treatment furnace 21 so that the core wore member 1 is annealed (see the center in Fig. 2). For example, stress removing annealing that removes or reduces a residual stress is performed, by increasing a temperature of the core wire member 1 to a high temperature in the heat treatment furnace 21 and, thereafter, gradually lowering the temperature.

After annealing is performed (see a right side in Fig. 2), a stress 22 in the core wire member 1 is reduced (or removed) as shown at a right lower side in Fig. 2. Then, in a case where the core wire member 1 is a core wire member that liable to generate a so-called spring back, the spring back does not occur or becomes less likely to occur.

### [Passivation film]

In the method of manufacturing an electroformed pipe according to the embodiment 1, in the core wire member preparation step (S1), the passivation film F may be formed on a surface of the core wire member 1, or surface treatment for a passivation film forming may be performed.

Fig. 3 is a figure for explaining a layered structure such as a passivation film F, a conductive layer 2, a support layer 3 and the like, which are formed by the method of manufacturing an electroformed pipe according to the embodiment 1. (symbol 12 indicating a conductive-layer-formed core wire member, and symbol 13 indicating the support-layer-formed core wire member 13). As shown in Fig. 3, the passivation film F (an oxide film) is formed on a surface of the core wire member 1. Alternatively, a surface of the core wire member 1 is subjected to surface treatment for forming a passivation film.

The passivation film F is an oxidized coated film (thin film) that is formed on a surface on metal. In a case where a material (raw material) of the core wire member 1 is a stainless steel, the passivation film F is a thin and dense film that is formed on a surface of the core wire member 1, where chromium contained in stainless steel is combined with oxygen.

The surface treatment of forming the passivation film is performed, for example, by immersing the core wire member 1 into a nitric acid aqueous solution having concentration of 0.5 to 3.0 wt% (electrolytic treatment may be performed).

### [Conductive layer forming step (S3)]

### [Support layer forming step (S5)]

### [Electrolytic plating]

In the method of manufacturing an electroformed pipe according to the embodiment 1, electrolytic plating of the conductive layer forming step (S3) and electrolytic plating of the support layer forming step (S5) are subsequently performed. The conductive layer 2 is formed around the core wire member 1 by performing electrolytic plating in the conductive layer forming step (S3) thus forming the conductive-layer-formed core wire member 12, and subsequently, the support layer 3 is formed around the conductive-layer-formed core wire member 12 by performing electrolytic plating in the support layer forming step (S5) thus forming the support-layer-formed core wire member 13 (see Fig. 4).

Fig. 4 is a figure for explaining a conductive layer forming step (S3) and a support layer forming step (S5) in the method of manufacturing an electroformed pipe according to the embodiment 1. The steps (S3, S5) for forming the conductive layer and the support layer by electroforming that uses electrolytic plating are described, using Fig. 4.

The core wire member 1 (the core wire member 1 subjected to annealing treatment or the core wire member 1 not subjected to annealing treatment, the core wire member 1 on which a passivation film is formed or the core wire member 1 on which a passivation film is not formed, the core wire member 1 subjected to surface treatment for forming a passivation film, the core wire member 1 not subjected to surface treatment for forming a passivation film) is wound around a supply roller 31, and is pulled by a gripping tool 35 on a right side. Between the supply roller 31 and the gripping roller 35, a load adjustment roller 32 and a conveyance roller 33 are disposed, and a predetermined tension is applied to the core wire member 1 while the core wire member 1 moves from a left side to a right side so that to prevent to generate excessive slackening.

Among plating baths 41 that perform electrolytic plating, the plating bath 41A disposed on a left side performs electrolytic plating for forming the conductive layer, and the plating bath 41B on a right side performs electrolytic plating for forming the support layer. Plating solutions (42A, 42B) are in the plating baths 41A and the plating bath (41B) respectively. A passing hole that allows the core wire member 1 to pass through a wall (plating bath 41) is formed in the wall. The plating solution 42 leaks through the passing holes, and is recovered by recovery baths 43 (43A, 43B), and is filtered by a filter, and is again returned to the plating baths 41 to be recycled.

Cleaning baths 44 (44A, 44B, 44C, 44D), that are provided for cleaning the core wire member 1 before and after plating, are disposed in front of and behind each of the plating baths 41 through which the core wire member 1 passes. Cleaning liquid 45 (45A, 45B, 45C, 45D) are in the cleaning baths 44 (44A, 44B, 44C, 44D). In the same manner as the plating bath 41, holes that allow the core wire member 1 to pass therethrough are formed in walls of the cleaning baths 44. The cleaning liquids 45 are leaked from these holes, are recovered by recover vessels 46 (46A, 46B, 46C, 46D), are filtered by filters, and are returned to the cleaning baths 44 again and are used in a recycling manner or are discarded. As the cleaning liquids 45, for example, pure water is used. As the cleaning liquids 45 in the recovery baths 46B, 46C and 46D), for example, pure water, to which an ion scavenger that scavenges ions in the preceding plating solution is added, may be used.

In the example shown in Fig. 4, the conductive layer forming step (S3) is performed using the cleaning bath 44A, the plating bath 41A and the cleaning bath 41B, and the support layer forming step (S5) is performed using the cleaning bath 44C, the plating bath 41B and the cleaning bath 44D. One of the cleaning baths 44B 44C may be omitted.

In the embodiment 1, electrolytic plating of the conductive layer forming step (S3) and electrolytic plating of the support layer forming step (S5) are successively (continuously) performed. That is, in the conductive layer forming step (S3), the conductive layer 2 is formed around the core wire member 1 using electrolytic plating in the plating bath 41A thus forming the conductive-layer-formed core wire member 12. Then, subsequently, in the support layer forming step (S5), the support layer 3 is formed around the conductive-layer-formed core wire member 12 using electrolytic plating in the plating bath 41B thus forming the support-layer-formed core wire member 13.

### [Support-layer-formed core wire member cutting step (S7)

In the support-layer-formed core wire member cutting step (S7), the support-layer-formed core wire member 13 is cut to a predetermined length (see a right side in Fig. 4).

That is, the support-layer-formed core wire member 13, on which the support layer 3 is formed in the support layer forming step (S5), is cut to a predetermined length (for example, 400 to 600 mm) by a cutting tool 36 in the support-layer-formed core wire cutting step (S7).

As shown in Fig. 4, the support-layer-formed core wire member 13 is gripped by gripping tools 35 and is pulled toward a right side. For example, a plurality of (at least three) gripping tools 35 (35A, 35B. 35C) are circulated.

The first gripping tool 35A moves, between positions P1 and P2, at the same speed as the support-layer-formed core-wire member 13 without gripping the support-layer-formed core wire member 13.

When the first gripping tool 35A moves to the position P2, the first gripping tool 35A grips the support-layer-formed core wire member 13 and moves toward the right side (When the first gripping tool 35A moves to the position P2, the second gripping tool 35B moves to the position P1).

When the first gripping tool 35A moves to the position P3, the second gripping tool 35B moves to the position P2 and grips the support-layer-formed core wire member 13 (The third gripping tool 35C arrives at the position P1). Then, the cutting tool 36 cuts (severs) the support-layer-formed core wire member 13 in the vicinity of the position P2 (between the positions P2 and P3, cuts in the vicinity of the first gripping tool 35A). Then, the first gripping tool 35A releases the gripping of the support-layer-formed core wire member 13 so that the support-layer-formed core wire member 13, that is cut to a predetermined length, falls downward.

The second and third gripping tools (35B, 35C) are also controlled so as to perform the same operation as the first gripping tool 35A. The support-layer-formed core wire members 13, that are cut to the predetermined length, fall one after another. The support-layer-formed core wire members 13 that are cut in this manner are conveyed to the next step.

### ([Conductive layer forming step (S3)], [Support layer forming step (S5)])

### [Stirring of plating solution 42]

In the method of manufacturing an electroformed pipe according to the embodiment 1, in performing electrolytic plating of the core wire member 1 or the conductive-layer-formed core wire member 12 in the plating bath 41 (41A, 41B) containing plating solutions 42 (42A, 42B), plating solutions 42 (42A, 42B) are stirred, and electrolytic plating is performed and the core wire member 1 or the conductive-layer-formed core wire member 12 is moved and is made to pass in the long axis direction through in the stirred plating solution.

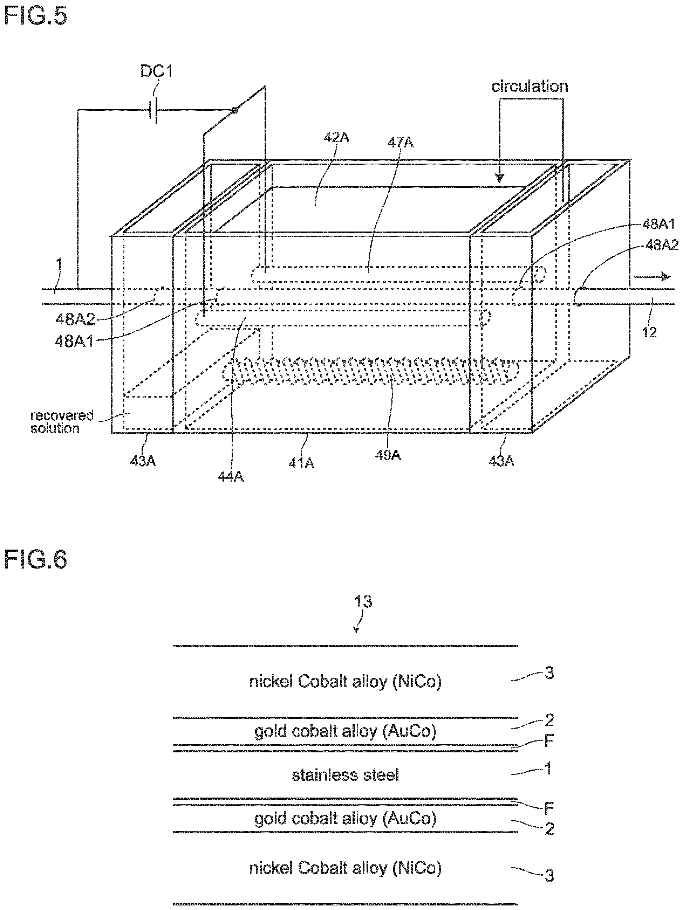

Fig. 5 is a figure for explaining the electrolytic plating treatment in the method of manufacturing an electroformed pipe according to the embodiment 1. The electrolytic plating process is basically the same as the electrolytic plating that forms the conductive layer 2 and the electrolytic plating (S3, S5) that forms the support layer 3, and hence, in Fig. 5, electrolytic plating for forming the conductive layer 2 is described.

When electrolytically plating the core wire 1 in the plating bath 41A, the electrolytic plating is performed by moving (while moving) the core wire member 1 in the long axis direction (from the left side to the right side in Fig. 5). 48A1, 48A2 are holes formed in the plating bath 41A and the recovery bath 43A that allow the core wire member 1 to pass therethrough respectively.

The core wire member 1 and an electrode plate 47A are disposed below the position of the hole 48A1 formed in the plating bath 41A. Although the plating solution 42A leaks out from the hole 48A1, the plating solution 42A is always replenished such that a level of the solution is above the position of the hole 48A1. A cathode of a direct current power source DC1 is connected to the core wire member 1 (member to be plated), and an anode is connected to the electrode plate 47A. As the electrode plate 47A, a metal used for plating may be used, but for example, platinum or the like may be used. In that case, as a plating solution, a gold-cobalt alloy plating solution, that is, a solution (an aqueous solution and the like) in which metal ions of gold and cobalt for forming plating is dissolved is used. For example, an aqueous solution in which gold ions are dissolved and an aqueous solution in which cobalt ions are dissolved are prepared, and such aqueous solutions are suitably replenished so that the measured concentration of gold ions or cobalt ions in the plating solution 42A is held at a constant value. What is formed using electrolytic plating is a gold cobalt alloy layer (layer thickness: 1 µm) that contains 0.3wt% of cobalt.

The support layer 3 is formed in the same manner. A solution (an aqueous solution) in which metal ions of nickel and cobalt for forming plating is dissolved is used. For example, an aqueous solution in which nickel ions are dissolved and an aqueous solution in which cobalt ions are dissolved are prepared, and such aqueous solutions are suitably replenished so that the measured concentration of nickel ions or cobalt ions in the plating solution 42A is held at a constant value. What is formed using electrolytic plating is a nickel cobalt alloy layer (layer thickness: 25 µm) that contains 4.0 to 35.0wt% of cobalt.

In the plating bath 41A, rotary blades 49A of a stirrer (a motor) are disposed such that a long axis direction of the blades is aligned with the long axis direction of the core wire member 1. When the rotary blades 49A rotate around the long axis, the plating solution 42A is stirred. The plating solution 42A is stirred such that at least the flow of the plating solution 42A, in the direction orthogonal to the long axis direction of the plating solution 42A, is generated around the core wire member 1 (or between the core wire member 1 and the electrode plate 47A).

### [Formation of conductive layer using alloy]

Fig. 6 is a figure for explaining a support-layer-formed core wire member 13 in the method of manufacturing an electroformed pipe according to the embodiment 1. As shown in Fig. 6, in the support-layer-formed-core wire member 13, a conductive layer 2 (AuCo alloy) and the support layer 3 (NiCo alloy) are stacked on the core wire member 1(stainless steel). In a case where the passivation film F is formed, the passivation film F is formed between the core wire member 1 and the conductive layer 2.

In the method of manufacturing an electroformed pipe according to the embodiment 1, in the conductive layer forming step (S3), the conductive layer 2 is formed of an alloy of one or more elements selected from a group consisting of Au, Ag, Pd and Pt and one or more elements selected from a group consisting of Co and Ni.

In forming the conductive layer 2 using an alloy, an AuNi alloy, an AgCo alloy, an AgNi alloy, a PdCo alloy, a PdNi alloy, a Pt Co alloy or a PtNi alloy may be used.

### [Crack forming step (S9)]

Fig. 7 is a figure for explaining a crack forming step (S9) in the method of manufacturing an electroformed pipe according to the embodiment 1.

In the crack forming step (S9) shown in Fig. 7, a crack-formed-support-layer-formed core wire member 13K, where a crack K is formed in the support layer 3, is formed by swinging the cut support-layer-formed core wire member 13 while gripping one end or both ends in the long axis direction of the cut support-layer-formed core wire member 13.

In the method of manufacturing an electroformed pipe according to the embodiment 1, in the crack forming step (S9), the crack K is formed at least on the support layer 3 adjacent to the gripping portion.

To explain further, with respect to the support-layer-formed core wire member 13 that is cut in the support-layer-formed core wire member cutting step (S7, see the right side in Fig. 4), in the crack forming step (S9), one end, in the long axis direction, of the support-layer-formed core wire member 13 is gripped (clamped) by a gripping tool 51 (clamping device), and the other end of the support-layer-formed core wire member 13 is gripped by a gripping tool 52 (a plier) manually (or using an arm of a machine)(see an upper figure in Fig. 7).

When the gripping tool 52 is swung on such a state, the support-layer-formed core wire member 13 is swung in a direction that intersects with the long axis direction and hence, the crack K is generated at a portion between portions gripped by the gripping tool 51 and the gripping tool 52 (lower figure in Fig. 7). When the gripping tool 52 is swung such that an angle, made by the long axis direction of the support-layer-formed core wire member 13 at the gripping portion G1 of the gripping tool 52, and the long axis direction of the support-layer-formed core wire member 13 at a left side of the gripping tool 52, becomes large, the crack K is generated in the support layer 3 at the portion G2 adjacent to the gripping portion G1 (a lower figure in Fig. 7). (In the same manner, at the gripping portion gripped by the gripping tool 51, when the gripping tool 52 is swung such that an angle, made by the long axis direction of the support-layer-formed core wire member 13 at the gripping portion, and the long axis direction of the support-layer-formed core wire member 13 at the right side of the gripping tool 51, becomes large, the crack K is formed in the support layer 3 at the portion adjacent to the gripping portion gripped by the gripping tool 51).

In this manner, the support-layer-formed core wire member 13 is formed into the crack-generated support-layer-formed core wire member 13K where the crack K is generated in the support layer 3.

### [Gap forming step (S11)]

Fig. 8 is a figure for explaining a gap forming step (S11) in the method of manufacturing an electroformed pipe according to the embodiment 1.

In the gap forming step (S11) shown in Fig. 8, by pulling the crack-generated support-layer-formed core wire member 13 (see lower figure in Fig. 7) while gripping the crack-generated support-layer-formed core wire member 13, a portion of the core wire member 1 beyond the crack K is deformed such that a cross-sectional area is decreased thus forming a gap S between the deformed core wire member 1 and the conductive layer 2 and a gap support-layer-formed core wire member 13S is formed.

That is, as shown in Fig. 8, by pulling the crack generated support-layer-formed core wire member 13K toward a right side using the gripping tool 51 while maintaining a state where the core wire member 13K is gripped in the crack forming step (see S9, Fig. 7), the support layer 3 and the conductive layer 2 are broken by the crack K and hence, the core wire member 1 beyond the crack K is deformed such that its cross-sectional area is decreased. And the gap support-layer-formed core wire member 13S is formed, where the gap S is formed between the deformed core wire member 1 and the conductive layer 2.

### [Gap support-layer-formed core wire member cutting step]

In the method of manufacturing an electroformed pipe according to the embodiment 1, between the gap forming step (S11) and the fixing step(S13), a gap-support-layer-formed core wire member cutting step, such as the gap support-layer-formed core wire member 13S is cut to a predetermined length (for example, 40 to 60 mm), may be further provided (not shown).

### [Fixing step (S13)]

Fig. 9 is a figure for explaining a fixing step (S13) in the method of manufacturing an electroformed pipe according to the embodiment 1.

In the fixing step (S13) shown in Fig. 9, a plurality of gap support-layer-formed core wire members 13S are fixed to a cutting jig 60 (60A, 60B, 60C) on which walls 62 or grooves 65 are formed in a state where the gap support-layer-formed core wire members 13S are arranged in parallel along the walls 62 or the grooves 65 and fixed with resin thus forming a core wire member fixing block B1 (a length of the wall 62 or the groove 65 is a length of 40 to 60 mm that corresponds to a length of the gap support-layer-formed core wire member 13S).

In the method of manufacturing electroformed pipe according to the embodiment 1, in the fixing step (S13), a resin 63 in a powdery form is sprayed on the cutting jig 60 or the gap support-layer-formed core wire members 13S and is solidified thus fixing the gap support-layer-formed core wire members 13S.

Four examples relating to the fixing step are shown in Fig. 9(a) to (d).

In the example shown in Fig. 9(a), the cutting jig 60 (60A) has a floor plate, having a flat upper surface 61,-and a wall member such that a pair of walls 62 is mounted on the upper surface 61 of the floor member in an opposed manner. A material of the floor plate and the wall member is a resin, carbon, glass or the like. A plurality of gap support-layer-formed core wire members 13S are arranged in parallel on the upper surface 61 of the floor plate along the walls 62 (parallel to the long axis direction), and, in that state, the gap support-layer-formed core wire members 13S are fixed by the resin 63, and a core wire member fixing block B1 is formed.

As the method of fixing the gap support-layer-formed core wire members 13S using the resin 63, for example, a method is considered where a thermoplastic resin is used as the resin 63, the resin 63 is formed into a powdery form and, thereafter, (a) the resin is sprayed on the plurality of gap support-layer-formed core wire members 13S which are arranged parallel, (b) the resin is sprayed, before or after the gap-support-layer formed core wire members 13S are arranged, on the upper surface 61 or on the gap support-layer-formed core wire members 13S, or (c) the resin is sprayed while arranging the gap support-layer-formed core wire members 13S and the like in parallel to each other (Fig.9(a), left figure).

Examples of such thermoplastic resins include resins such as polypropylene, polyethylene, polystyrene, acrylonitrile • butadiene • styrene, acryl (PMMA), polyamide and the like.

And the cutting jig 60 is made to pass through a heating tank so that the resin 63 is softened (for example, into a paste state) in the heating tank and, thereafter, a temperature is returned to a room temperature (cooling down) thus hardening the resin 63, and the core wire member fixing block B1, where the gap support-layer-formed core wire members 13S are fixed by the resin 63 in a state where the plurality of gap support-layer-formed core wire member 13S are arranged parallel-along the walls 62, is formed (Fig. 9(a), right figure). This method is used in the embodiment 1.

The example shown in FIG. 9(b) is basically the same as the example shown in FIG. 9(a). This is an example that a plurality of layers of the gap support-layer-formed core wire members 13S are stacked in the cutting jig 60 (60A) to form a core wire member fixing block B1. For example, a plurality of gap support-layer-formed core wire members 13S that form one layer are arranged in parallel and the resin 63 is sprayed to the gap support-layer-formed core wire members 13S, being passed through the heating tank (the resin 63 being softened and adhered to the gap support-layer-formed core wire member 13S), after being cured at a normal temperature, arranging the next layer in parallel and spraying the resin 63, passed through the heating tank, cured at a normal temperature, and by repeating the above steps, a core wire member fixing block B1, where a plurality of layers each of which is formed of the plurality of gap support-layer-formed core wire members 13S are stacked, is formed.

The example shown in FIG. 9(c) is basically the same as the example shown in FIG. 9(a). However, it differs from the example shown in Fig. 9(a) with respect to a point that the cutting jig 60 (60A) has also walls 64 in the long axis direction of the gap support-layer-formed core wire members 13S, and that grooves 65 (65B) are formed on an upper surface 63 of a floor plate.

A plurality of gap support-layer-formed core wire member 13S are arranged such that one end positions of the gap support-layer-formed core wire member 13S, in the long axis direction, are aligned by the wall 64 of the cutting jig 60 (60B). And the plurality of gap support-layer-formed core wire rods 13S with gap support layers have their long axis aligned along the wall 62 and the groove 65 (65A).

Note that the structure of the cutting jig 60 (60B) may be such that the wall 64 is formed but the groove 65 (65A) is not formed, or the wall 64 is not formed but the groove 65 (65A) is formed.

The example shown in FIG. 9(d) is basically the same as the example shown in FIG. 9(a). However, it differs from the example shown in Fig. 9(a) with respect to a point that the cutting jig 60 (60C) has a groove 65 (65B) instead of a wall 62. And the plurality of gap support-layer-formed core wire rods 13S with gap support layers have their long axis aligned along the groove 65 (65A).

A thermosetting resin may be used as the resin 63. In that case, for example, the resin is formed in a fluid state (a liquid state, a paste state) at a normal temperature, and is, by coating, pouring, and the like, fed to between the gap support-layer-formed core wire members 13S or between the gap support-layer-formed core wire member 13S and the cutting jig 60. Then, the resin is heated and cured. Examples of such thermosetting resins include resins such as an epoxy resin, an unsaturated polyester resin, thermosetting polyimide and the like.

An adhesive resin may be also used as the resin 63.

### [Block cutting step (S15)]

Fig. 10 is a figure for explaining a block cutting step (S15) in the method of manufacturing an electroformed pipe according to the embodiment 1.

In the method of manufacturing an electroformed pipe according to the embodiment 1, in the block cutting step (S15), the core wire member fixing block B1 is cut in a short-axis direction of the core wire members 1 thus forming a post-cut core wire member fixing block B2 (a cut length being 3 mm that is a length of the electroformed pipe 4).

The term "short-axis direction" means a direction that is orthogonal to the long axis. The "short-axis direction" is not limited to a direction that is completely orthogonal to the long-axis, and includes a direction where an angle sandwiched between the long axis and the short axis is 30 degrees or 40 degrees (same for other portions in this specification).

In this block cutting step (S15), the core wire member fixing block B1 is sequentially cut by displacing the core wire member fixing block B1 in the long axis direction of the core wire member 1 (see Fig. 10(a)), or the core wire member fixing block B1 is simultaneously cut at a plurality of positions (see Fig. 10(a)).

### [Sequential cutting]

Fig. 10(a) is a figure for explaining sequential cutting of the core wire member fixing block B1. A cutting machine 70(70A) has a mounting base 71, on which the core wire member fixing block B1(an object to be cut) is mounted, a drive roller 75, that moves a cutting wire 77 at a high speed, and a driven roller 76. The cutting wire 77 is wound between the drive roller 75 and the driven roller 76, and cuts the core wire member fixing block B 1 while moving between the drive roller 75 and the driven roller 76 at a high speed. A recessed portion 72, into which the core wire member fixing block B1 (the object to be cut) is fitted, is formed on the mounting base 71, and the core wire member fixing block B1 can be moved along the recessed portion 72 by pushing.

When the core wire member fixing block B1 is pushed and pops out the end portion of the recessed portion 72, the mounting base 71 is moved in a direction of the cutting wire 77 whereby the core wire member fixing lock B1 is cut in a short axis direction of the core wire member 1, and the post-cut core wire member fixing block B2 is formed. When cutting is finished, the core wire member fixing block B1 is pushed so that a new portion to be cut runs out from the end portion of the recessed portion 72. Then, the mounting base 71 is moved in the direction of the cutting wire 77 so that new portion to be cut is cut whereby the post-cut core wire member fixing block B2 is formed. In this manner, the core wire member fixing blocks B 1 is sequentially cut and hence, the post-cut core wire member fixing blocks B2 is sequentially formed.

In a case where the gap support-layer-formed core wire member 13S in the core wire member fixing block B1 (or the core wire member 1 in the core wire member fixing block B 1) or the like is deformed or the like by gripping or the like in the gap forming step (S11), a portion that is deformed or the like is cut and removed. The portion to be removed by cutting is mainly, the first or the last portion (an end portion of the core wire member fixing block B1) when the core wire member fixing blocks B 1 are sequentially cut.

### [Simultaneous cutting]

Fig. 10(b) is a figure for explaining simultaneous cutting of the core wire member fixing block B 1. Basically, the simultaneous cutting is the same as the sequential cutting. However, the simultaneous cutting differs from the sequential cutting with respect to some points, and the description is made by focusing on such different points. A cutting machine 70 (70B) has the mounting base 71, a setting tool 73, that is mounted on the mounting base 71 (the core wire member fixing block B1 being set by the setting tool 73), the drive roller 75, and the driven roller 76. A plurality of cutting wires 77 are wound around the driven roller 76 in parallel, and the plurality of cutting wires 77 arranged in parallel moves from a drive roller 75 side to a driven roller 76 side at a high speed.

When the mounting base 71 moves in a direction of the cutting wires 77, the core wire member fixing block B1 is cut simultaneously (not just exactly at the same time but also almost at the same time are included) at a plurality of portions in a short axis direction and hence, a plurality of post-cut core wire member fixing blocks B2 are formed.

In a case where the gap support-layer-formed core wire member 13S in the core wire member fixing block B1 (or the core wire member 1 in the core wire member fixing block B 1) or the like is deformed or the like by gripping or the like in the gap forming step (S11), a portion that is deformed or the like is cut and removed. The portion to be cut and removed is mainly an end portion of the core wire member fixing block B1 when the core wire member fixing block B 1 is simultaneously cut.

In Fig. 10(a) (sequential cutting) and in Fig. 10(b) (simultaneous cutting), the cutting wire 77 may be moved in a direction of a mounting base 71, instead of moving the mounting base 71 in the direction of the cutting wire 77.

Further, in any cutting methods including the sequential cutting and the simultaneous cutting, the gap support-layer-formed core wire member 13S is cut from the outside in a fixed state by the resin 63 and hence, the deformation of the core wire member 1 or the support layer 3 by cutting minimally occurs.

Further, in any cutting methods including the sequential cutting and the simultaneous cutting, cutting may be performed by using abrasive grains (an artificial or natural material in a granular or powdery form having high hardness).

### [Core wire member removing step (S17)]

Fig. 11 is a figure for explaining a core wire member removing step (S17) in the method of manufacturing an electroformed pipe according to the embodiment 1.

In the method of manufacturing an electroformed pipe according to the embodiment 1, in the core wire member removing step(S17), the core wire members 1 are removed from the post-cut core wire member fixing block B2, by inclining the post-cut core wire member fixing block B2, in liquid or gas, such that the long axis direction of the core wire member 1 becomes a vertical direction, or by cleaning, thus forming the core wire member removed fixing block B3.

The post-cut core wire member fixing block B2 is a block having the core wire members 1 and the support layer 3 in a state where these components are not deformed by gripping and hence, in the core wire member removing step (S17), the core wire members 1 are removed from such post-cut core wire member fixing block B2.

Although a cut end portion of the post-cut core wire member fixing block B2 is cleanly cut without deforming the core wire members 1 and the support layer 3, a cut debris is liable to adhere to a gap S between the core wire member 1 and the conductive layer 2 (mainly a gap at the end portion). Or, in a case where cutting is performed using abrasive grains, the abrasive grains are liable to easily enter the gap S. However, by inclining or cleaning the post-cut core wire member fixing block B2, the debris or the like generated by cutting are removed and hence, it is possible to remove the core wire members 1 without generating flaws on the conductive layers 2 or the like by the core wire members 1.

In the method of manufacturing an electroformed pipe according to the embodiment1, in the core wire member removing step (S17), in a case where the post-cut core wire member fixing block B2 is cleaned in liquid, the core wire member 1 is removed from the post-cut core wire member fixing block B2 by performing ultrasonic cleaning, by moving the liquid or by moving the core wire member removed fixing block B3.

### [Inclining post-cut core wire member fixing block B2]

Fig. 11(a) is a figure for explaining the removing of the core wire members 1 by inclining the post-cut core wire member fixing block B2. In this case, as shown in Fig. 11(a), the post-cut core wire member fixing block B2 is gripped by a gripping tool 81 (81A), and the post-cut core wire member fixing block B2 is inclined in a cleaning liquid or in air in a state where a long axis direction of the core wire member 1 becomes a vertical direction. As a result, the core wire members 1 fall by gravity and are removed thus forming the core wire member removed fixing block B3. The phrase "the long axis direction is a vertical direction" does not mean that the long axis direction is completely the same direction as the vertical line, and means that a case where the inclined long axis direction contains a vector component in a vertical line direction (same for other portions).

And, when the gripping tool 81 (81A) is moved, the removing of the core wire members 1 is promoted.

### [Cleaning post-cut core wire member fixing block B2]

Fig. 11(b) is a figure for explaining the removing of the core wire members 1 by cleaning the post-cut core wire member fixing block B2 by ultrasonic cleaning. In this case, as shown in Fig. 11(b), the post-cut core wire member fixing block B2 is gripped by the gripping tool 81 (81A), and the post-cut core wire member fixing block B2 is cleaned in a cleaning liquid 85 by ultrasonic cleaning. An ultrasonic wave generator 87 is disposed in the cleaning liquid 85, and generates ultrasonic waves. As a result, fine bubbles 88 (cavitation) are generated in the cleaning liquid 85. These bubbles 88 inflate and are broken and hence, impact pulses 89 are generated, and cut debris and the like adhering in gaps S of the post-cut core wire member fixing block B2 are removed and hence, the cut core wire members 1 fall down and are removed from the post-cut core wire member fixing block B2. Then, the post-cut core wire member fixing block B2 becomes the core wire member removing fixing block B3. In Fig. 11(b), the post-cut core wire member fixing block B2 is inclined such that the core wire members 1 (long axis) in the post-cut core wire member fixing block B2 are directed in a vertical direction (such that core wire member has a vector component in the vertical direction).

The core wire members 1 are also removed by stirring the cleaning liquid 85, or by moving the post-cut core wire member fixing block B2 in the cleaning liquid 85.

And, the core wire members 1 are also removed by placing the post-cut core wire member fixing block B2 in air and cleaning with blowing high-pressure air to it.

The cleaning liquid may be an alkaline solution, an acidic solution, a solution containing a detergent or the like. Pure water may be also used.

The phrase "in air" may be "in a specific gas such as nitrogen" besides "in air".

### [Resin removing step (S19)]

Fig. 12 is a figure for explaining a resin removing step (S19) in the method of manufacturing an electroformed pipe according to the embodiment 1.

In the method of manufacturing an electroformed pipe according to the embodiment 1, in the resin removing step (S19), the resin 63 is removed from the core wire member removed fixing block B3 thus forming electroformed pipes 4 where the conductive layer 2 is left on an inner surface of the support layer 3. Such a state is schematically shown in Fig. 12.

In the method of manufacturing an electroformed pipe according to the embodiment 1, in the resin removing step (S19), the resin 63 is removed from the post-cut core wire member fixing block B2 by chemical dissolving of the resin 63 or peeling by melting the resin with heat.

In the embodiment 1, a thermoplastic resin is used as the resin 63. The resin 63 is dissolved chemically using a resin dissolving agent thus removing the resin 63 from the core wire member removed fixing block B3. As the resin dissolving agent, for example, there is e-solve21HE manufactured by KANEKO CHEMICAL., LTD (in a case where thermoplastic polyurethane is used as the resin 63). In addition, for example, the resin 63 may be removed using an alkaline cleaning agent. The alkaline cleaning agent is a cleaning agent that contains, as a main component, sodium carbonate, sodium hydroxide, potassium hydroxide, silicic acid (water glass), sodium phosphate or the like. The resin 63 is removed by pouring these cleaning agents on the core wire member removed fixing block B3, by immersing the core wire member removed fixing block B3 in such a cleaning agent and the like.

In a case where the resin 63 is a thermoplastic resin, the resin 63 is also removed by softening (melting) with heating.

And, in a case where a thermoplastic resin such as an epoxy resin is used as the resin 63, for example, the resin can be removed by using the above-mentioned resin dissolving agent e-solve21HE. Further, in a case where an adhesive resin is used as the resin 63, for example, a resin dissolving agent such as a toluene or benzene and the like can be used.

### [Diagram for explaining summary of steps]

Fig. 13 is a diagram for explaining a summary of the steps of the method of manufacturing an electroformed pipe according to the embodiment 1. Materials, sizes and the like of the core wire members 1, the conductive layer 2, the support layer 3 and the like explained heretofore are collectively written.

And, as shown in a lower part of Fig. 13, in the method of manufacturing an electroformed pipe according to the embodiment 1, with respect to the core wire member preparation step (S 1), the step is further subdivided into four forms. The form 1-(1) is a form where annealing treatment and passivation film forming treatment (or surface treatment) are performed in the core wire member preparation step (S1). In this form, it is preferable to perform the passivation film forming treatment after performing the annealing treatment. To further facilitate to form the passivation film, degreasing cleaning treatment may be performed between the annealing treatment and the passivation film forming treatment. The form 1-(2) is a form where only annealing treatment is performed. The form 1-(3) is a form where only passivation film forming treatment (or surface treatment) is performed. The form 1-(4) is a form where neither annealing treatment nor passivation film forming treatment (or surface treatment) is performed. The form 1-(1) is most preferable.

### [Advantageous effects acquired by method of manufacturing an electroformed pipe according to the embodiment 1]

According to the method of manufacturing an electroformed pipe according to the embodiment 1, the support-layer-formed core wire member 13 is formed into the crack-formed support-layer-formed core wire member 13K where a crack is formed in the support layer 13 in the crack forming step (S9). The crack-formed support-layer-formed core wire member 13 is formed into the gap support-layer-formed core wire member 13S where a gap is formed between the core wire member 1 and the conductive layer 2 is formed in the gap forming step (S11). The core wire member fixing block B1 where the plurality of gap support-layer-formed core wire members 13S are arranged in parallel and are fixed by the resin 63 is formed in the fixing step (S13). The post-cut core wire member fixing block B2 is formed by cutting the core wire member fixing block B 1 in the short axis direction of the core wire members 1 in the block cutting step (S15). The core wire member removed fixing block B3 from which the core wire members 1 are removed is formed by inclining or cleaning the post-cut core wire member fixing block B2 in the core wire member removing step (S17). The resin 63 is removed from the core wire member removed fixing block B3 in the resin removing step (S19) thus manufacturing the electroformed pipes 4 where the conductive layer 2 is left on the inner surface of the support layer 3. Therefore, deformed or burred core wire members are not pulled and removed from inside of the conductive layer, and it is possible to overcome at least one of serious problems relating to quality, that is, the problem that the conductive layer is liable to be easily peeled off from the fine wire member (the core wire member) at the time of removing the core wire member by pulling, the problem that flaws are liable to easily occur on the conductive layer, or the problem that the electroformed pipe is liable to be easily deformed.

In addition, although it is not easy to check the qualities in the inside of the electroformed pipe (peeling-off of the conductive layer 2, flaws or the like) it is also possible to eliminate or reduce the check according to the method of manufacturing an electroformed pipe according to the embodiment 1.

And, in a case where the core wire member 1 is a core wire member that is hardened due to the wire pulling treatment (treatment for decreasing a cross-sectional area by pulling the wire), a stress is eliminated or is reduced, by performing annealing treatment in the core wire member preparation step (S1) and it becomes easier to remove the core wire member 1 in the core wire removal step (S17). For example, in a case where the core wire member 1 that is wound around a reel is used, so-called spring back minimally occurs and it becomes easy to remove the conductive layer 2 without flawing it.

And, usually, before performing electrolyte plating, a passivation film F is removed or the surface treatment for removing a passivation film is performed so as to make plating easy. However, on the contrary, in the embodiment 1, in the core wire member preparation step (S 1), a passivation film F is formed on a surface of the core wire member 1 or surface treatment for forming a passivation film is performed, and adhesiveness of the conductive layer 2 to the core wire member 1 is weakened and hence, in the gap forming step (S11) that is the step performed in a later stage, a gap can be easily formed between the core wire member 1 and the conductive layer 2.

And, in case that electrolytic plating of the conductive layer forming step (S3) and electrolytic plating of the support layer forming step (S5) are subsequently performed and performing the formation of the support layer 3 using electrolytic plating subsequently to the formation of the conductive layer 2 using electrolytic plating, the adhesiveness of the support layer 3 to the conductive layer 2 can be further improved, a thickness control of the conductive layer 2 and the support layer 3 can be performed easily, or the inclusion of a foreign substance between the conductive layer 2 and the support layer 3 can be minimized. And the productivity can be remarkably enhanced compared to batch treatment (treatment of electrolytically plating the short core wire members 1 while pulling them up into each plating bath), by performing electrolytic plating in such a manner that the long core wire member 1 is made to successively pass through the respective plating baths in the long axis direction,

In applying electrolytic plating to the core wire members 1 or the conductive-layer-formed core wire members 12 in the plating baths 41 (41A, 41B) containing with a plating solution 42 (42A, 42B), if the plating solution 42 (42A, 42B) is stirred, when performing electrolytic plating by moving the core wire members 1 or the conductive-layer-formed core wire members 12 through the stirred plating solution in the longitudinal axis direction, it is easy to achieve uniform plating layer thickness not only in the longitudinal axis direction but also in the circumferential direction (in the short axis direction).

And, in the conductive layer forming step (S3), in a case where the conductive layer 2 is formed of an alloy of one or more elements selected from a group consisting of Au, Ag, Pd and PT, and one or more elements selected from a group consisting of Co and Ni, a harder conductive layer 2 can be formed compared to a case where the conductive layer 2 is formed of pure Au, pure Ag, pure Pd or pure Pt. Therefore, it is possible to form a conductive layer 2 that is hard to be flawed.

In the crack forming step (S9), in a case where a crack K is formed in the support layer 3 adjacent to at least the gripping portion, it is possible to adjust the crack K forming position by selecting the gripping position.

In case that the method further has a gap support-layer-formed core wire member cutting step of forming the gap support-layer-formed core wire member 13S into the gap support-layer-formed core wire member 13S cut to a predetermined length, between the gap forming step (S 11) and the fixing step (S13), a length of the gap support-layer-formed core wire member 13S can be adjusted to a length of the cutting tool 60. For example, in a case where various kinds of electroformed pipes 4 are required, by cutting the gap support-layer-formed core wire member 13S to a predetermined length in the support-layer-formed core wire member cutting step (S7), and by further cutting the gap support-layer-formed core wire member 13S to lengths of the cutting jigs 60 that correspond to various kinds of electroformed pipes 4, the electroformed pipes 4 having various lengths can be further easily manufactured.

In a case where the gap support-layer-formed core wire member 13S has deformation caused by gripping in the gap forming step (S11), it is also possible to form the gap support-layer-formed core wire member 13S where a portion that is deformed or the like is cut and removed.

And, in the fixing step (S 13), in case that a resin 63 in a powdery form is sprayed to the cutting jig 60 or the gap support-layer-formed core wire member 13S and is solidified thus fixing the gap support-layer-formed core wire member 13S, it becomes possible to cut the gap support-layer-formed core wire member 13S, having a small cross-sectional area and elongated, without making it unstable (without causing it to wobble). Particularly, It is possible to prevent wobbling in the short axis direction. Therefore, it is possible to suppress (or prevent) the bending of the gap support-layer-formed core wire member 13 in the short axis direction, or the distortion of the cut cross section (of the core wire member 1, the conductive layer 2 or the support layer 3).

And, in the block cutting step (S15), in case that the core wire member fixing block B 1 is sequentially cut while displacing the core wire member fixing block B 1 in a long axis direction of the core wire member 1, for example, the small lot production of electroformed pipes 4 having different lengths can be easily performed. Further, by cutting the core wire member fixing block B1 at a plurality of positions simultaneously, for example, the large lot production of electroformed pipes 4 having the same length can be easily performed.

In a case where the gap support-layer-formed core wire member 13S has deformation caused by gripping in the gap forming step (S11), it is also possible, regardless of sequential cutting or simultaneous cutting, and the like, to form the post-cut core wire member fixing block B2 by cutting and removing the portions where the deformation and the like occurred in the block cutting step (S15).

And, in the core wire member removing step (S17), in a case where the post-cut core wire member fixing block B2 is cleaned in liquid, the core wire member 1 is removed from the post-cut wire member fixing block B2 by performing ultrasonic cleaning, by moving the liquid or by moving the core wire member removed fixing block B3, it becomes possible to more easily remove the core wire 1 without causing serious quality problems, without causing serious problems, such as peeling off of the core wire members 1 of the conductive layer 2, flaws on the conductive layer 2, or deformation of the electroformed pipe 4.

And, in case that, in the resin removing step (S19), the resin 13 is removed from the core wire member removed fixing block B3 by chemical dissolving of the resin 63 or by melting the resin 63 with heat, it becomes possible to remove the resin 63 even more easily.

### [Embodiments 2 to 11]

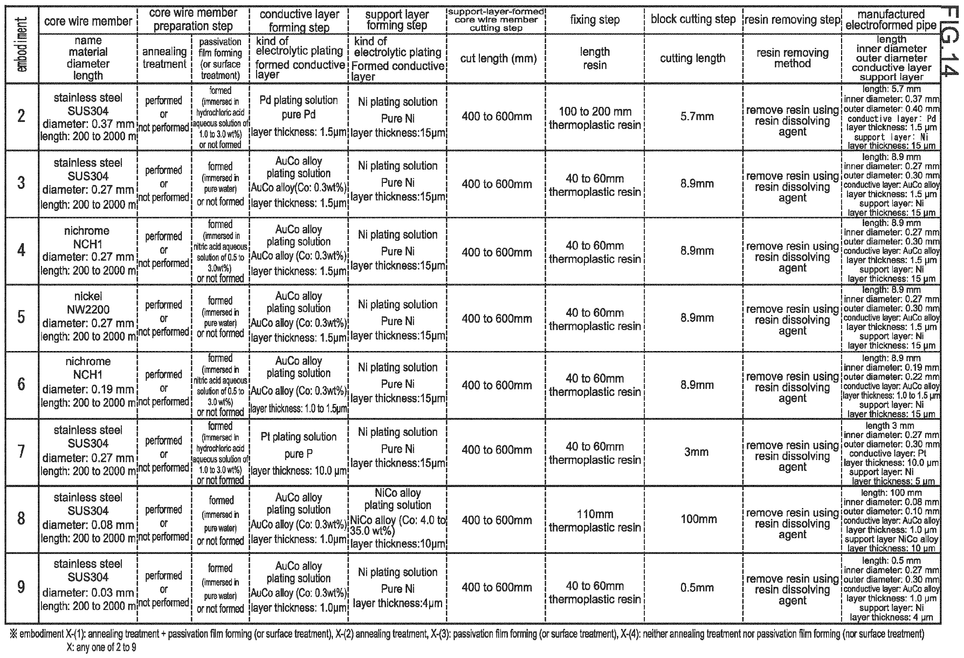

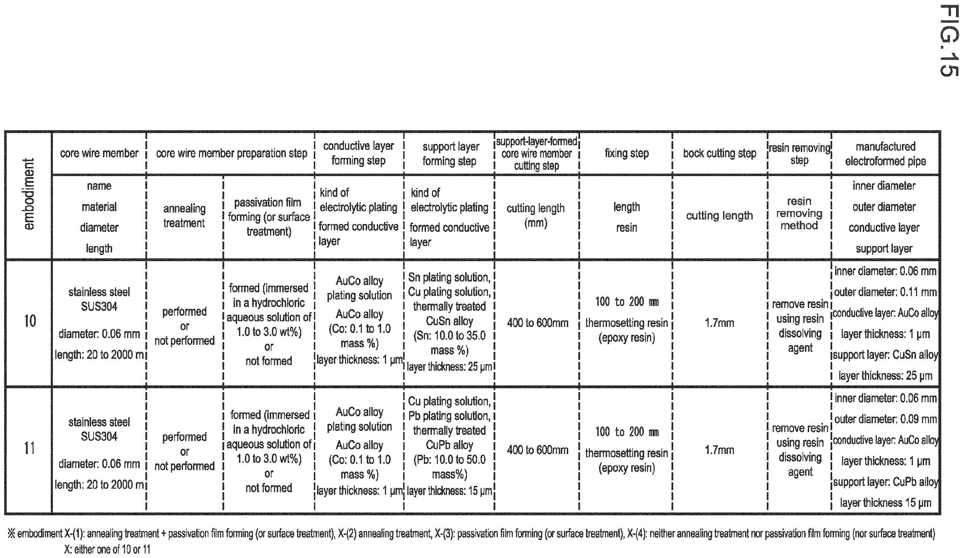

Fig. 14 and Fig. 15 are diagrams for explaining the summary of the steps of the method of manufacturing an electroformed pipe according to the embodiments 2 to 11.

Methods of manufacturing an electroformed pipe according to the embodiments 2 to 9 (see Fig. 14) and the embodiments 10 and 11 (see Fig. 15) are basically the same as the method of manufacturing an electroformed pipe according to the embodiment 1. However, either the material of the core wire member 1, its dimensions, the core wire preparation step (S1), the conductive layer forming step (S3), the support layer forming step (S5), the fixing step (S13), the block cutting step (S15), and the like are different. And, either the length of the electroformed tube 4 to be manufactured, its inner diameter, its outer diameter, the material of the conductive layer 2, its layer thickness, material of the support layer 3, or its layer thickness is different.

Further, these methods differ from the method of manufacturing an electroformed pipe according to the embodiment 1 with respect to any one of a length, an inner diameter, and an outer diameter of the manufactured electroformed pipe 4, a material and a layer thickness of the conductive layer 2, and a material and a layer thickness of the support layer 3.

These are as written in the diagrams of Figs. 14 and 15. Note that the contents of the diagrams in FIGS. 14 and 15 are assumed to be written in the specification, and as a general rule, are omitted from being written in text.

With respect to the core wire member 1, in the embodiments 2, 3, 7 to 9, and 10 to 11, stainless steel (SUS304) is used as the core wire member 1 in the same manner as the embodiment 1. However, these embodiments differ from the embodiment 1 with respect to a diameter (see Fig. 14 and Fig. 15). Nichrome (NCH1, nickel-chromium÷ type 1) is used in the embodiments 4 and 6, and nichrome (JIS code NW2200) is used in the embodiment 5. The diameters are as shown in Fig. 14. And, in the embodiments 2 to 9, the length of the core wire member 1 is the same as in the embodiment 1. However, in the embodiments 10 and 11, the length range is different from the embodiment 1 (see Fig. 14 and Fig. 15).

With respect to the core wire member preparation step (S1), also in the embodiments 2 to 11, the step (S1) is divided into four forms depending on the presence or the non-presence of annealing treatment and the formation of a passivation film (or surface treatment) in the same manner as the embodiment 1. The description on a lower part in Fig. 14 and Fig. 15 is the explanation relating to four embodiments X-(1) to X-(4) obtained by further subdividing the embodiment X (X being any one of 2 to 11) (see the explanation of [Diagram explaining summary of steps] of the embodiment 1.

With respect to the formation of a passivation film (or surface treatment), in the embodiments 4, 6, 10, 11, the core wire member is immersed in a nitric acid aqueous solution of 0.5 to 3.0 WT% (mass %) in the same manner as the embodiment 1. However, in the embodiments 2 and 7, the core wire member is immersed in a nitric acid aqueous solution of 1.0 to 3.0 WT%. And, in the embodiments 3, 5, 8 and 9, the core wire member is immersed in pure water. In case of pure water, a passivation film formation (or surface treatment) is performed by oxygen dissolved in pure water.

With respect to the conductive layer forming step (S3), in the embodiments 3 to 6, 8 and 9, the conductive layer 2 of AuCo alloy is formed by electrolytic plating using AuCo alloy plating solution in the same manner as the embodiment 1. However, the conductive layer 2 of pure Pd is formed by electrolytic plating using Pd plating solution in the embodiment 2, and the conductive layer 2 of pure Pt plating is formed by electrolytic plating using Pt plating solution in the embodiment 7.

Layer thicknesses of the respective conductive layers 2 are as shown in Fig. 14.

And, in the embodiments 10 and 11, the conductive layer 2 of AuCo alloy is formed by electrolytic plating using AuCo alloy plating solution in the same manner as the embodiment 1, and the range of Co mass % of the AuCo alloy is slightly different from Embodiment 1. Layer thicknesses of the respective conductive layers 2 are shown in Fig. 15.

With respect to the support layer forming step (S5), in the embodiment 8, the support layer 3 of NiCo alloy is formed by electrolytic plating using NiCo alloy plating solution in the same manner as the embodiment 1. In the embodiments 2 to 7 and 9, the conductive layer 2 of pure Ni is formed using electrolytic plating using Ni plating solution. Layer thicknesses of the respective support layers 3 are shown in Fig. 14.

In the embodiment 10, an Sn layer is formed by electrolytic plating using an Sn plating solution and, on the Sn layer, a Cu layer is formed by electrolytic plating using a Cu plating solution and, thereafter, the entirety of them is heat treated (for example, heat treatment within a range of 150°C to 210°C) and an alloyed CuSn alloy layer (conductive layer 2) is formed. A layer thickness of the CuSn alloy layer (conductive layer 2) and Sn content ratio in CuSn alloy are shown in Fig. 15.

In the embodiment 11, a Cu layer is formed by electrolytic plating using a Cu plating solution and, on the Cu layer, a Pb layer is formed by electrolytic plating using a Pb plating solution and, thereafter, the entirety of them is heat treated (for example, heat treatment within a range of 450°C to 550°C ) and an alloyed CuPb alloy layer (conductive layer 2) is formed. A layer thickness of the CuPb alloy layer (conductive layer 2) and Pb content ratio in CuPb alloy are shown in Fig. 15.

With respect to the support-layer-formed core wire member cutting step (S7), a cut length of the embodiments 2 to 11 is the same as the embodiment 1 (400 to 600mm).

With respect to the fixing step (S13), in any of embodiments 2 to 11, the core wire members are further cut, in the same manner as the embodiment 1, such that the lengths of the core wire members become equal to the length of the cutting jig 60. The respective cutting lengths are shown in Fig. 14 and Fig. 15.

The resins of the embodiments 2 to 9 used in the fixing step are all thermoplastic resins same as that of embodiment 1.

On the other hand, the resins of the embodiments 10 to 11 used in the fixing step are all thermosetting resins (epoxy resins).

With respect to the block cutting step (S15), the respective cutting lengths (eventually becoming lengths of electroformed pipe 4) according to the embodiments 2 to 11 are as shown in Fig. 14 and Fig. 15.

With respect to the resin removing step (S19), in the same manner as the embodiment 1, the resin 63 is, in the same manner as the embodiment 1, removed from the core wire member removed fixing block B3 by dissolving the resin 63 using a resin dissolving agent, and the electroformed pipe 4, while leaving the conductive layer 2 on the inner surface of the support layer 3, is formed.

On a right side in Fig. 14 and Fig. 15, a length, an inner diameter and an outer diameter of each of the manufactured electroformed pipes 4, a material and a layer thickness of each conductive layer 2, and a material and a layer thickness of each support layer 3 are shown.

### [Advantageous effects acquired by methods of manufacturing an electroformed pipe according to embodiments 2 to 11]

The methods of manufacturing an electroformed pipe according to embodiments 2 to 11 differ from the method of manufacturing an electroformed pipe according to the embodiment 1 with respect to the material of the core wire member 1 or the like. However, they are same as the embodiment 1 with respect to other points and they have same effects as embodiment 1 with respect to other same points. Accordingly, the methods of manufacturing an electroformed pipe according to embodiments 2 to 11 acquire the same advantageous effects with respect to the substantially same to other points.

### [Modifications]

Although the present invention has been explained based on the above-mentioned embodiments, the present invention is not limited to the above-mentioned embodiments. The present invention can be modified without departing from the gist of the present invention. For example, the following modifications are also possible.

(1) In the above-mentioned embodiments 1 to 3, 7 to 9, 10 and 11, stainless steel (SUS304) is used as the core wire member 1. However, stainless steel is not limited to stainless steel (SUS304). For example, stainless steel (SUS303) may be used.
(2) In the above-mentioned embodiments 1 to 11, the cross section of the core wire member 1 has a circular shape. However, the cross section of the core wire member 1 is not limited to a circular shape. For example, the cross section of the core wire member 1 may be a triangular shape, a quadrangular shape (a square shape, a rectangular shape), or a polygonal shape such as a pentagonal shape and the like.
(3) In the above-mentioned embodiment, the support layer 3 formed in the support layer forming step (S5) is one layer. However, the support layer 3 is not limited to one layer. For example, the support layer 3 may be a plurality of layers such as two layers or three layers and the like. In the same manner, the conductive layer 2 formed in the conductive layer forming step (S3) is one layer. However, the conductive layer 2 is not limited to one layer. It may be a plurality of layers.

### Reference Signs List

1: core wire member
12: conductive-layer-formed core wire member
13: support-layer-formed core wire member
2: conductive layer
3: support layer
F: a passivation film
21: heat treatment furnace
22: stress
31: supply roller
32: load adjustment roller
33: conveyance roller
35: gripping tool
36: cutting tool
P1, P2, P3: position
41, 41A, 41B: plating bath
42, 42A, 42B: plating solution
43, 43A, 43B: recovery bath
44, 44A to 44D: cleaning bath
45, 45A to 45D: cleaning liquid
46, 46A to 46D: recovery bath
47: electrode
48A1, 48A2: hole
DC 1: direct current power source
49A: stirring machine
51: gripping tool
52: gripping tool
K: crack
13K: crack-formed-support-layer-formed core wire member
13S: gap support-layer-formed core wire member
S: gap
60, 60A, 60B, 60c: cutting tool
61: floor member
62: wall
63: resin
65: groove
61: floor member
B1: core wire member fixing block
B2: post-cut core wire member fixing block
B3: core wire member removed fixing block
70, 70A, 70B: cutting machine
71: mounting base
72: recessed portion
73: setting tool
75: drive roller
76: driven roller
77: cutting wire
81, 81A, 81B: gripping tool
82: pan
85: cleaning liquid
86: cleaning bath
87: ultrasonic generator
88: bubbles
89: impact wave

## Claims

1. A method of manufacturing an electroformed pipe by forming a support layer, formed with an electrodeposited material or surrounding material by electroforming, around a core wire member that has an outer peripheral surface on which a conductive layer is formed,
and the core wire member is removed while leaving the conductive layer on an inner surface of the support layer, wherein
the method of manufacturing an electroformed pipe comprising:
a core wire member preparation step of preparing the core wire member that is used in manufacturing the electroformed pipe;
a conductive layer forming step of forming a conductive layer by electroforming around the core wire member using electrolytic plating thus forming a conductive-layer-formed core wire member;
a support layer forming step of forming a support layer by electroforming around the conductive-layer-formed core wire member using electrolytic plating thus forming a support-layer-formed core wire member;
a support-layer-formed core wire member cutting step of cutting the support-layer-formed core wire member to a predetermined length;
a crack forming step of forming a crack in the support layer by swinging the cut support-layer-formed core wire member while gripping one end or both ends of the support-layer-formed core wire member in a long axis direction thus forming a crack-formed support-layer-formed core wire member;
a gap forming step of pulling the crack-formed support-layer-formed core wire member while gripping the crack-formed support-layer-formed core wire member thus deforming the crack-formed support-layer-formed core wire member such that a cross-sectional area of the core wire member beyond the crack is decreased whereby a gap is formed between the deformed core wire member and the conductive layer thus forming a gap-support-layer-formed core wire member;
a fixing step of arranging a plurality of gap-support-layer-formed core wire members in parallel, on a cutting jig on which a wall or grooves are formed, along the wall or the grooves, and fixing the gap-support-layer-formed core wire members by a resin thus forming a core wire member fixing block;
a block cutting step of forming a post-cut core wire member fixing block by cutting the core wire member fixing block in a short axis direction of the core wire members thus forming the post-cut core wire member fixing block;
a core wire member removing step of removing a core wire members from the post-cut core wire member fixing block, in liquid or in air, by inclining the post-cut core wire member fixing block such that a long axis direction of the core wire members becomes a vertical direction or by cleaning forming the core wire member removed fixing block; and
a resin removing step of removing the resin from the core wire member removed fixing block thus forming an electroformed pipe while leaving the conductive layer on an inner surface of the support layer.

2. The method of manufacturing an electroformed pipe according to claim 1 wherein,
in the core wire member preparation step, annealing treatment is applied to the core wire member, in a case where the core wire member is a core wire member that is hardened due to by performing pulling treatment where the core wire member is pulled such that a cross-sectional area of the core wire member is decreased.

3. The method of manufacturing an electroformed pie according to Claim 1 or Claim 2 wherein,
in the core wire member preparation step, a passivation film is formed on a surface of the core wire member or surface treatment for forming a passivation film is performed.

4. The method of manufacturing an electroformed pipe according to any one of claims 1 to 3, wherein
electrolytic plating of the conductive layer forming step and electrolytic plating of the support layer forming step are subsequently performed, such that
the conductive layer is formed around the core wire member by performing electrolytic plating in the conductive layer forming step thus forming the conductive-layer-formed core wire member and, subsequently, the support-layer-formed core wire member is formed by forming the support layer around the conductive-layer-formed core wire member by performing electrolytic plating in the support layer forming step.

5. The method of manufacturing an electroformed pipe according to claim 4, wherein
in applying electrolytic plating to the core wire member or the conductive-layer-formed core wire member in a plating bath containing a plating solution, the plating solution is stirred so that the electrolytic plating is performed by making the core wire member or the conductive-layer-formed core wire member move and pass in the stirred plating solution in a long axis direction.

6. The method of manufacturing an electroformed pipe according to any one of claims 1 to 5, wherein
in the conductive layer forming step, the conductive layer is formed of an alloy of one or more elements selected from a group consisting of Au, Ag, Pd, and Pt, and one or more elements selected from a group consisting of Co and Ni.

7. The method of manufacturing an electroformed pipe according to any one of claims 1 to 6, wherein
in the crack forming step, a crack is formed in the support layer at least adjacent to a gripping portion.

8. The method of manufacturing an electroformed pipe according to any one of claims 1 to 7, wherein
the method has a gap support-layer-formed core wire cutting step of forming the gap support-layer-formed core wire member into the gap support-layer-formed core wire member cut to a predetermined length, between the gap forming step and the fixing step.

9. The method of manufacturing an electroformed pipe according to any one of claims 1 to 8, wherein
in the fixing step, a resin in a powdery form is sprayed to the cutting jig or the gap support-layer-formed core wire member and is solidified thus fixing the gap support-layer-formed core wire member.

10. The method of manufacturing an electroformed pipe according to any one of claims 1 to 9, wherein
in the block cutting step, the core wire member fixing block is sequentially cut while displacing the core wire member fixing block in a long axis direction of the core wire member, or the core wire member fixing block is simultaneously cut at a plurality of portions.

11. The method of manufacturing an electroformed pipe according to any one of claims 1 to 10, wherein
in the core wire member removing step, in a case where the post-cut core wire member fixing block is cleaned in liquid, the core wire member is removed from the post-cut wire member fixing block by performing ultrasonic cleaning, by moving the liquid or by moving the post-cut wire member fixing block.

12. The method of manufacturing an electroformed pipe according to any one of claims 1 to 11, wherein
in the resin removing step, the resin is removed from the core wire member removed fixing block by chemical dissolving of the resin or by melting the resin with heat.
